# EUROPEAN PATENT APPLICATION

(11) **EP 4 362 220 A1**
(43) Date of publication of application: **01.05.2024**
(21) Application number: 23204711.8
(22) Date of filing: 19.10.2023
(51) Int. Cl.: H01Q 1/27, H01Q 5/321, G04R 60/10

(54) **ANTENNA SYSTEM WITH CONDUCTIVE SHIELDING AND LOSS MITIGATION**

(30) Priority: 26.10.2022 US 202218049756
(71) Applicant: Meta Platforms Technologies, LLC, Menlo Park, CA 94025 (US)
(72) Inventor: ZHANG, Ce, Menlo Park (US); WEI, Yonghua, Menlo Park (US); HUANG, Danyang, Menlo Park (US); ISLAM, Md Rashidul, Menlo Park (US); YE, Geng, Menlo Park (US); MARTIN, Bruno, Menlo Park (US)
(74) Representative: Murgitroyd & Company

(57) **Abstract**

The disclosed system may include a printed circuit board (PCB) within an enclosure. The system may further include a first antenna affixed to an upper layer of the enclosure above the PCB as well as a second antenna affixed to a lower layer of the enclosure below the PCB. The system may also include a decoupling switch that links the first antenna to the second antenna through the PCB. The decoupling switch may selectively couple the first and second antennas when transmitting or receiving signals above a specified minimum frequency and may decouple the first and second antennas when transmitting or receiving signals below a specified maximum frequency. Various other apparatuses, mobile electronic devices, and methods of manufacturing are also disclosed.

## Description

### FIELD OF INVENTION

The present disclosure is directed to an antenna architecture that includes multiple antennas linked via a decoupling switch, for example to be applied to mobile electronic devices such as smartwatches and to systems, mobile electronic devices and methods embodying the principles of the same.

### BACKGROUND

In some cases, mobile electronic devices such as smartwatches may suffer from poor antenna reception. Such mobile devices may have enclosures that, for industrial design reasons or for durability reasons, may be made of metal or other conductive material. This metal may cause absorption or interference problems for the various antennas that are intended to operate within the smartwatch.

The embodiments herein may be designed to reduce or remove these concerns by implementing an alternative antenna architecture.

### SUMMARY OF INVENTION

In accordance with the invention in a first aspect, a system comprises:
a printed circuit board (PCB) within an enclosure;
a first antenna affixed to an upper layer of the enclosure above the PCB;
a second antenna affixed to a lower layer of the enclosure below the PCB; and a decoupling switch that links the first antenna to the second antenna through the PCB, wherein the decoupling switch selectively couples the first and second antennas when transmitting or receiving signals above a specified minimum frequency and decouples the
first and second antennas when transmitting or receiving signals below a specified maximum frequency.

In some embodiments, the system further comprises a third antenna affixed to the lower layer.

In some embodiments, the third antenna includes one or more antenna tuners.

In some embodiments, the one or more antenna tuners on the third antenna allow for dynamic tuning between different frequency bands.

In some embodiments, the system further comprises a first spring clip that electrically links the first antenna to the decoupling switch.

In some embodiments, the system further comprises a second spring clip that electrically links the second antenna to the decoupling switch.

In some embodiments, the system further comprises a touchscreen display and a conductive shield positioned beneath the touchscreen display.

In some embodiments, the conductive shield is driven, thereby functioning as the first antenna.

In some embodiments, the conductive shield below the touchscreen display includes one or more tuners.

In some embodiments, the one or more tuners on the conductive shield comprise aperture tuners.

In some embodiments, the enclosure is made of a conductive material, and the PCB extends to an inner surface of the enclosure and is electrically grounded to the enclosure.

In some embodiments, the PCB shields the second antenna from the touchscreen display.

In accordance with the invention in a second aspect, a mobile electronic device is provided comprising:
a printed circuit board (PCB) within an enclosure;
a first antenna affixed to an upper layer of the enclosure above the PCB;
a second antenna affixed to a lower layer of the enclosure below the PCB; and a decoupling switch that links the first antenna to the second antenna through the PCB, wherein the decoupling switch selectively couples the first and second antennas when transmitting or receiving signals above a specified minimum frequency and decouples the first and second antennas when transmitting or receiving signals below a specified maximum frequency.

Thus, the mobile electronic device is for example a mobile electronic device comprising a system of the first aspect, and features of embodiments of the mobile electronic device will be understood by analogy.

In some embodiments, the device further comprises a first antenna feed integrated into the PCB, wherein the first antenna feed is electrically connected to the decoupling switch.

In some embodiments, the device further comprises a second antenna feed integrated into the PCB, wherein the second antenna feed is electrically connected to the second antenna.

In some embodiments, the device further comprises third antenna feed integrated into the PCB, wherein the third antenna feed is electrically connected to a third antenna.

In some embodiments, the third antenna comprises a patch antenna having at least one aperture for at least one sensor.

In some embodiments, the device further comprises a bottom conductive shielding positioned between the PCB and the second antenna.

In some embodiments, the bottom conductive shielding comprises a second PCB.

In accordance with the invention in a third aspect, a method of manufacturing comprises:
providing a printed circuit board (PCB) within an enclosure;
affixing a first antenna affixed to an upper layer of the enclosure above the PCB;
affixing a second antenna affixed to a lower layer of the enclosure below the PCB; and providing a decoupling switch that links the first antenna to the second antenna through the PCB, wherein the decoupling switch selectively couples the first and second antennas when transmitting or receiving signals above a specified minimum frequency and decouples the first and second antennas when transmitting or receiving signals below a specified maximum frequency.

Thus, the methid is for example a a method of manufacturing system of the first aspect, for example to comprise a mobile device of the second aspect,and features of embodiments of the method will be understood by analogy

### BRIEF DESCRIPTION OF THE DRAWINGS

The accompanying drawings illustrate a number of exemplary embodiments and are a part of the specification. Together with the following description, these drawings demonstrate and explain various principles of the present disclosure.
FIG. 1A is a plan view of an example wristband system, according to at least one embodiment of the present disclosure.
FIG. 1B is a side view of the example wristband system of FIG. 1A, according to at least one embodiment of the present disclosure.
FIG. 2A is a perspective view of an example wristband system, according to at least one embodiment of the present disclosure.
FIG. 2B is a side view of another example wristband system, according to at least one embodiment of the present disclosure.
FIG. 2C is a perspective view of another example wristband system, according to at least one embodiment of the present disclosure.
FIG. 3 illustrates a side view of an antenna architecture that may be implemented in a mobile electronic device.
FIG. 4 illustrates a top view of an alternative antenna architecture that may be implemented in a mobile electronic device.
FIG. 5 illustrates a bottom view of an alternative antenna architecture that may be implemented in a mobile electronic device.
FIG. 6 illustrates a side view of an alternative antenna architecture that may be implemented in a mobile electronic device.
FIG. 7 illustrates a top perspective view of an alternative antenna architecture that may be implemented in a mobile electronic device.
FIG. 8 illustrates a diagram of a combined radio frequency (RF) signal that may be sent to different antennas based on the state of a decoupling switch.
FIG. 9 illustrates a side view of an alternative antenna architecture that may be implemented in a mobile electronic device.
FIG. 10 is a flow diagram of an exemplary method for manufacturing a mobile electronic device that includes one or more of the antenna architectures described herein.
FIG. 11 is an illustration of exemplary augmented-reality glasses that may be used in connection with embodiments of this disclosure.
FIG. 12 is an illustration of an exemplary virtual-reality headset that may be used in connection with embodiments of this disclosure.

Throughout the drawings, identical reference characters and descriptions indicate similar, but not necessarily identical, elements. While the exemplary embodiments described herein are susceptible to various modifications and alternative forms, specific embodiments have been shown by way of example in the drawings and will be described in detail herein. However, the exemplary embodiments described herein are not intended to be limited to the particular forms disclosed. Rather, the present disclosure covers all modifications, equivalents, and alternatives falling within the scope of the appended claims.

### DETAILED DESCRIPTION OF EXEMPLARY EMBODIMENTS

The present disclosure is directed to an antenna architecture that includes multiple antennas linked via a decoupling switch. In some cases, mobile electronic devices such as smartwatches may suffer from poor antenna reception. Such mobile devices may have enclosures that, for industrial design reasons or for durability reasons, may be made of metal or other conductive material. This metal may cause absorption or interference problems for the various antennas that are intended to operate within the smartwatch.

The embodiments herein may be designed to reduce or remove these concerns by implementing an antenna architecture that strategically positions antennas within the mobile device and combines antenna feeds using a decoupling switch. This decoupling switch may be used to route some frequencies to antennas on an upper layer that may be nearer to a display and further from a user's body, and may route other frequencies to antennas that are further from the display and may be closer to a user's body. In some cases, the mobile device's display may be a touchscreen display and may include, for example, an indium tin oxide (ITO) layer. This ITO layer may absorb some antenna signals. Furthermore, the mobile device's bottom side may be placed on or near the user's body (e.g., on the user's wrist). This close contact may cause degradation in signal quality due to absorption by the user's body. The absorption and signal degradation may not be consistent among different frequency bands.

For example, at least in some cases, higher frequencies (e.g., >1GHz) may be routed to antennas on an upper layer. Such frequencies may be less affected by the display's ITO layer. Moreover, lower frequencies (e.g., <1GHz) may be routed to antennas on the lower layer. These frequencies may be less affected by the user's body and may not be absorbed as much as higher frequency signals. In some embodiments, the antenna architectures described herein may include a high frequency antenna below the display that is connected to a main PCB via a decoupling switch.

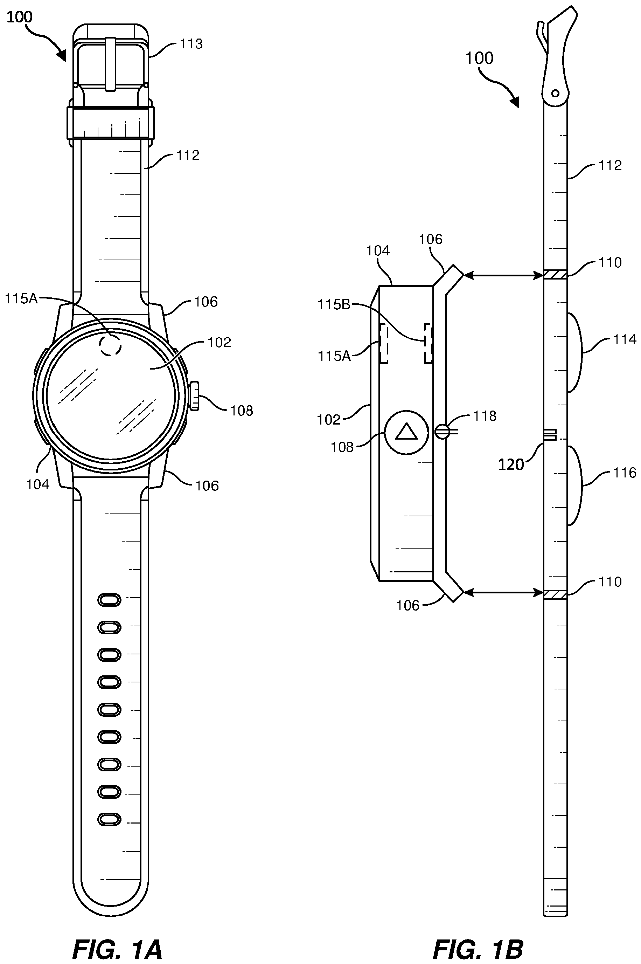

When the decoupling switch is closed, an incoming combined RF signal (e.g., including WiFi/GPS/MB/HB LTE, etc.) may be routed to the antenna on the upper layer and to a separate, smaller lower layer antenna. When the decoupling switch is open, the combined RF signal may be routed solely to the separate, smaller lower layer antenna. Other frequency signals (e.g., <1GHz) may be routed to a larger lower antenna that is, at least in some cases, on the same plane as the smaller lower layer antenna. The embodiments herein may also provide different tuner ports to allow the larger lower layer antenna to tune to different cellular or other frequency bands. Such embodiments may greatly improve antenna efficiency, as will be explained below in greater detail with regard to FIGS. 1-12.

Features from any of the embodiments described herein may be used in combination with one another in accordance with the general principles described herein. These and other embodiments, features, and advantages will be more fully understood upon reading the following detailed description in conjunction with the accompanying drawings and claims.

Mobile electronic devices often use many different types of antennas for communication on different frequency bands. For instance, current smartwatches may implement wide- and multi-band long-term evolution (LTE), global positioning system (GPS), wireless fidelity (WiFi), Bluetooth^{™}, near field communication (NFC), or other types of antennas. These different types of antennas may provide long- and short-range communications with other electronic devices and with networks such as cellular networks or the internet.

However, as mobile devices become ever smaller, the amount of space available for these different types of antennas may be limited. Moreover, because of the small size, the amount of bandwidth achievable on any given antenna may be limited. Still further, because mobile devices such as smartwatches are often designed with metal enclosures, placing multiple different types of antennas in different locations where they can receive sufficient operational signal strength may be complicated. In some instances, the size of the mobile device may be increased to accommodate larger antennas. This increased size may, at least in some cases, improve antenna bandwidth and efficiency. However, larger sizes for smartwatches and other mobile devices may be less desirable, as additional weight and bulk in a mobile (especially wearable) device are typically unwanted. Still further, having a metal enclosure may limit how and where different types of antennas may be placed and operated within a mobile device.

As noted above, wearable devices may be configured to be worn on a user's body, such as on a user's wrist or arm. Such wearable devices may be configured to perform a variety of functions. A wristband system, for example, may be an electronic device worn on a user's wrist that performs functions such as delivering content to the user, executing social media applications, executing artificial-reality applications, messaging, web browsing, sensing ambient conditions, interfacing with head-mounted displays, monitoring the health status associated with the user, etc. In some examples, a wristband system may include a watch band that detachably couples to a watch body. The watch body may include a coupling mechanism for electrically and mechanically coupling the watch body (e.g., the enclosure or capsule) to the watch band (e.g., the cradle). At least in some cases, the wristband system may have a split architecture that allows the watch band and the watch body to operate both independently and in communication with one another. The mechanical architecture may include a coupling mechanism on the watch band and/or the watch body that allows a user to conveniently attach and detach the watch body from the watch band.

The wristband system of FIGS. 1A and 1B, for example, may be used in isolation or in conjunction with other systems including artificial-reality (AR) systems. Sensors of the wristband system (e.g., image sensors, inertial measurement units (IMUs), etc.) may be used, for example, to enhance an AR application running on the AR system. Further, the watch band may include sensors that measure biometrics of the user. For example, the watch band may include neuromuscular sensors disposed on an inside surface of the watch band contacting the user that detects the muscle intentions of the user. The AR system may include a head-mounted display that is configured to enhance a user interaction with an object within the AR environment based on the muscle intentions of the user. Signals sensed by the neuromuscular sensors may be processed and used to provide a user with an enhanced interaction with a physical object and/or a virtual object in an AR environment. For example, the AR system may operate in conjunction with the neuromuscular sensors to overlay one or more visual indicators on or near an object within the AR environment such that the user could perform "enhanced" or "augmented" interactions with the object.

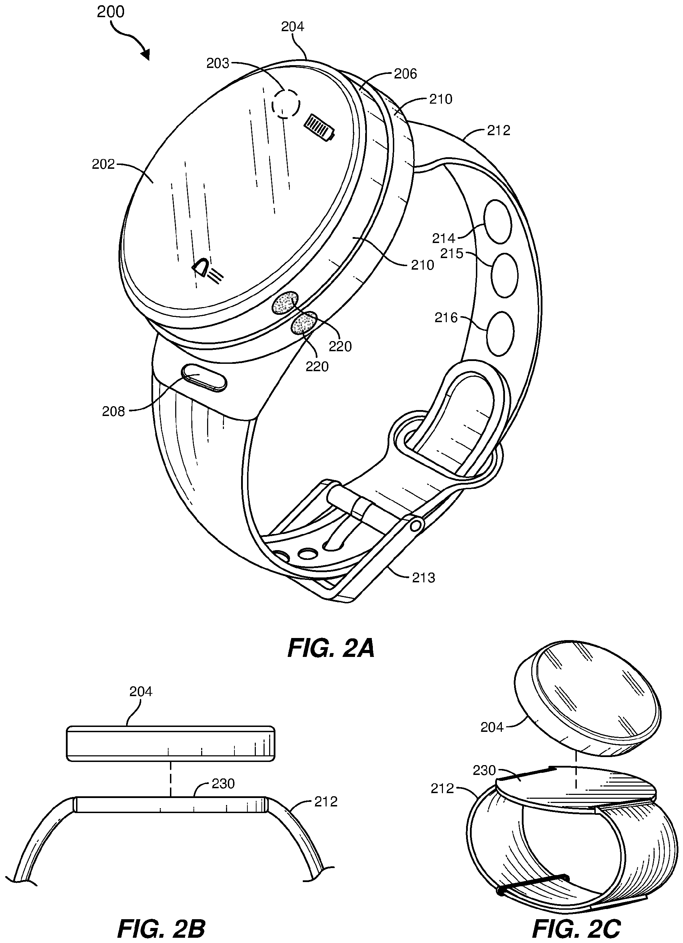

FIGS. 1A and 1B illustrate an embodiment of a wristband system including a watch band and a watch body. In some cases, neuromuscular sensors may be integrated within the wristband system, as shown in FIGS. 2A, 2B, and 2C. FIG. 1A illustrates an example wristband system 100 that includes a watch body 104 coupled to a watch band 112. Watch body 104 and watch band 112 may have any size and/or shape that is configured to allow a user to wear wristband system 100 on a body part (e.g., a wrist). Wristband system 100 may include a retaining mechanism 113 (e.g., a buckle) for securing watch band 112 to the user's wrist. Wristband system 100 may also include a coupling mechanism 106, 110 for detachably coupling watch body 104 to watch band 112. Still further, the wristband system 100 may include a button or wheel 108 that allows users to interact with the wristband system 100 including applications that run on the system.

Wristband system 100 may perform various functions associated with the user. The functions may be executed independently in watch body 104, independently in watch band 112, and/or in communication between watch body 104 and watch band 112. Watch band 112 and its associated antennas may be configured to operate independently (e.g., execute functions independently) from watch body 104. Additionally or alternatively, watch body 104 and its associated antennas may be configured to operate independently (e.g., execute functions independently) from watch band 112. At least in some cases, watch band 112 and/or watch body 104 may each include the independent resources required to independently execute functions. For example, watch band 112 and/or watch body 104 may each include a power source (e.g., a battery), a memory, data storage, a processor (e.g., a CPU), communications (including multiple different types of antennas), a light source (e.g., at least one infrared LED for tracking watch body 104 and/or watch band 112 in space with an external sensor), and/or input/output devices.

FIG. 1B illustrates an example wristband system 100 that includes a watch body 104 decoupled from a watch band 112. Watch band 112 may be donned (e.g., worn) on a body part (e.g., a wrist) of a user and may operate independently from watch body 104. For example, watch band 112 may be configured to be worn by a user and an inner surface of watch band 112 may be in contact with the user's skin. When worn by a user, sensor 114 may be in contact with the user's skin. Sensor 114 may be a biosensor that senses a user's heart rate, bioimpedance, saturated oxygen level, temperature, sweat level, muscle intentions, steps taken, or a combination thereof. Watch band 112 may include multiple sensors 114 and 116 that may be distributed on an inside surface, in an interior volume, and/or on an outside surface of watch band 112. In some examples, watch body 104 may include an electrical connector 118 that mates with connector 120 of watch band 112 for wired communication and/or power transfer. In some examples, as will be described further below, watch body 104 and/or watch band 112 may include wireless communication devices including LTE antennas, GPS antennas, Bluetooth antennas, WiFi antennas, NFC antennas, or other types of antennas.

Wristband system 100 may include a coupling mechanism for detachably coupling watch body 104 to watch band 112. A user may detach watch body 104 from watch band 112 in order to reduce the encumbrance of wristband system 100 to the user. Detaching watch body 104 from watch band 112 may reduce a physical profile and/or a weight of wristband system 100. Wristband system 100 may include a watch body coupling mechanism(s) 106 and/or a watch band coupling mechanism(s) 110. A user may perform any type of motion to couple watch body 104 to watch band 112 and to decouple watch body 104 from watch band 112. For example, a user may twist, slide, turn, push, pull, or rotate watch body 104 relative to watch band 112, or a combination thereof, to attach watch body 104 to watch band 112 and to detach watch body 104 from watch band 112.

As illustrated in FIG. 1B, in some examples, watch body 104 may include front-facing image sensor 115A and rear-facing image sensor 115B. Front-facing image sensor 115A may be located in a front face of watch body 104 (e.g., substantially near, under, or on the display 102), and rear-facing image sensor 115B may be located in a rear face of watch body 104. In some examples, a level of functionality of at least one of watch band 112 or watch body 104 may be modified when watch body 104 is detached from watch band 112. The level of functionality that may be modified may include the functionality of front-facing image sensor 115A and/or rear-facing image sensor 115B. Alternatively, the level of functionality may be modified to change how the various antennas within the system. For instance, as will be described further below, the embodiments herein may include a cosmetic RF transparent feature that may form a functional link between wrist strap antennas and internal electronic components including tuners, amplifiers, controllers, and data processors.

FIG. 2A illustrates a perspective view of an example wristband system 200 that includes a watch body 204 decoupled from a watch band 212. Wristband system 200 may be structured and/or function similarly to wristband system 100 of FIGS. 1A and 1B. Watch body 204 and watch band 212 may have a substantially rectangular or circular shape and may be configured to allow a user to wear wristband system 200 on a body part (e.g., a wrist). Wristband system 200 may include a retaining mechanism 213 (e.g., a buckle, a hook and loop fastener, etc.) for securing watch band 212 to the user's wrist. Wristband system 200 may also include a coupling mechanism 208 for detachably coupling watch body 204 to watch band 212. The watch body 204 may include an enclosure 206 that houses various electronic components. In some cases, the watch body 204 may be referred to as a "capsule."

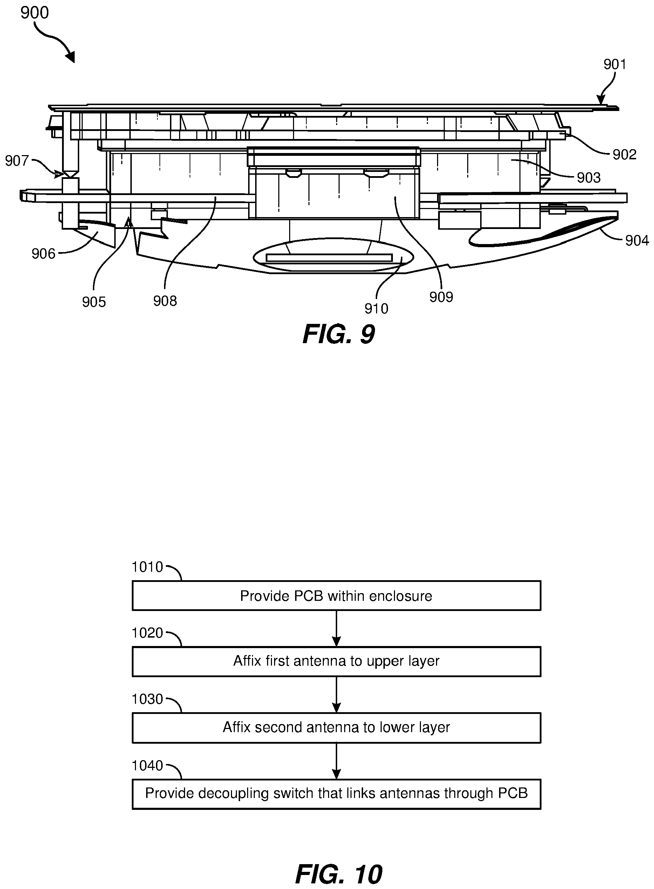

Wristband system 200 may perform various functions associated with the user as described above with reference to FIGS. 1A and 1B. The functions executed by wristband system 200 may include, without limitation, display of visual content to the user (e.g., visual content displayed on display screen 202), sensing user input (e.g., sensing a touch on a touch bezel 210 or on a physical button, sensing biometric data on sensor 214, sensing neuromuscular signals on neuromuscular sensors 215 or 216, sensing audio input via microphones 220, etc.), messaging (e.g., text, speech, video, etc.), image capture (e.g., with a front-facing image sensor 203 and/or a rear-facing image sensor), wireless communications (e.g., cellular, near field, WiFi, personal area network, etc.), location determination, financial transactions, providing haptic feedback, alarms, notifications, biometric authentication, health monitoring, sleep monitoring, etc. These functions may be executed independently in watch body 204, independently in watch band 212, and/or in communication between watch body 204 and watch band 212. Functions may be executed on wristband system 200 in conjunction with an artificial-reality system such as the artificial-reality systems described in FIGS. 9 and 10.

Watch band 212 may be configured to be worn by a user such that an inner surface of watch band 212 may be in contact with the user's skin. When worn by a user, sensor 214 may be in contact with the user's skin. Sensor 214 may be a biosensor that senses a user's heart rate, saturated oxygen level, temperature, sweat level, muscle intentions, or a combination thereof. Watch band 212 may include multiple sensors 214 that may be distributed on an inside and/or an outside surface of watch band 212. Additionally or alternatively, watch body 204 may include the same or different sensors than watch band 212. For example, multiple sensors may be distributed on an inside and/or an outside surface of watch body 204 or on the surface of the wrist straps. The watch body 204 may include, without limitation, front-facing image sensor 115A, rear-facing image sensor 115B, a biometric sensor, an IMU, a heart rate sensor, a saturated oxygen sensor, a neuromuscular sensor(s), an altimeter sensor, a temperature sensor, a bioimpedance sensor, a pedometer sensor, an optical sensor, a touch sensor, a sweat sensor, etc.

Watch band 212 may transmit the data acquired by sensor 214 to watch body 204 using a wired communication method (e.g., a UART, a USB transceiver, etc.) and/or a wireless communication method (e.g., near field communication, Bluetooth^{™}, etc.). Watch band 212 may be configured to operate (e.g., to collect data using sensor 214) independent of whether watch body 204 is coupled to or decoupled from watch band 212. In some examples, watch band 212 may include a neuromuscular sensor 215 (e.g., an electromyography (EMG) sensor, a mechanomyogram (MMG) sensor, a sonomyography (SMG) sensor, etc.). Neuromuscular sensor 215 may sense a user's muscle intention. Neuromuscular sensor 215 may include neuromuscular sensor 1810 of FIG. 18A.

FIG. 2B is a side view and FIG. 2C is a perspective view of another example wristband system. The wristband systems of FIGS. 2B and 2C may include a watch body interface 230 or "cradle." Watch body 204 may be detachably coupled to watch body interface 230. In additional examples, one or more electronic components may be housed in watch body interface 230 and one or more other electronic components may be housed in portions of watch band 212 away from watch body interface 230.

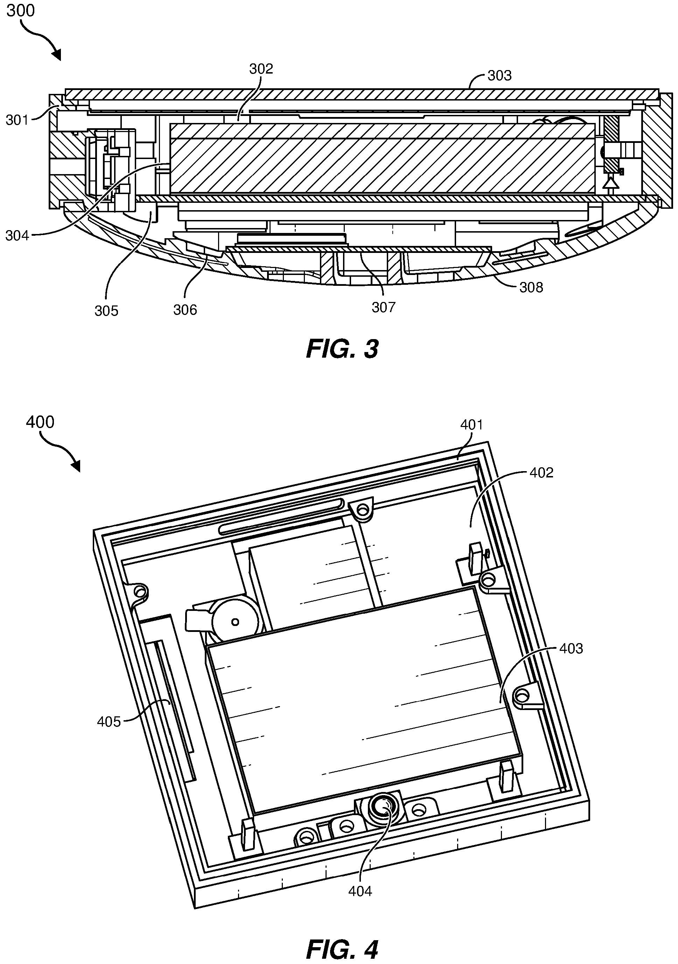

The following will provide, with reference to FIGS. 3-12, detailed descriptions of systems and wearable electronic devices that implement different antenna architectures in different scenarios. Features from any of the embodiments described herein may be used in combination with one another in accordance with the general principles described herein. These and other embodiments, features, and advantages will be more fully understood upon reading the following detailed description in conjunction with the accompanying drawings and claims.

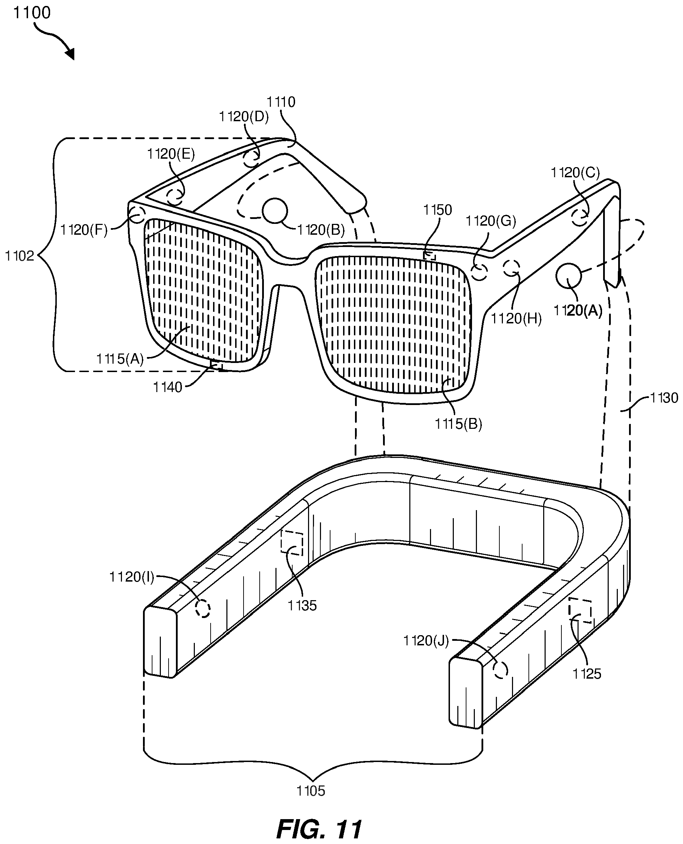

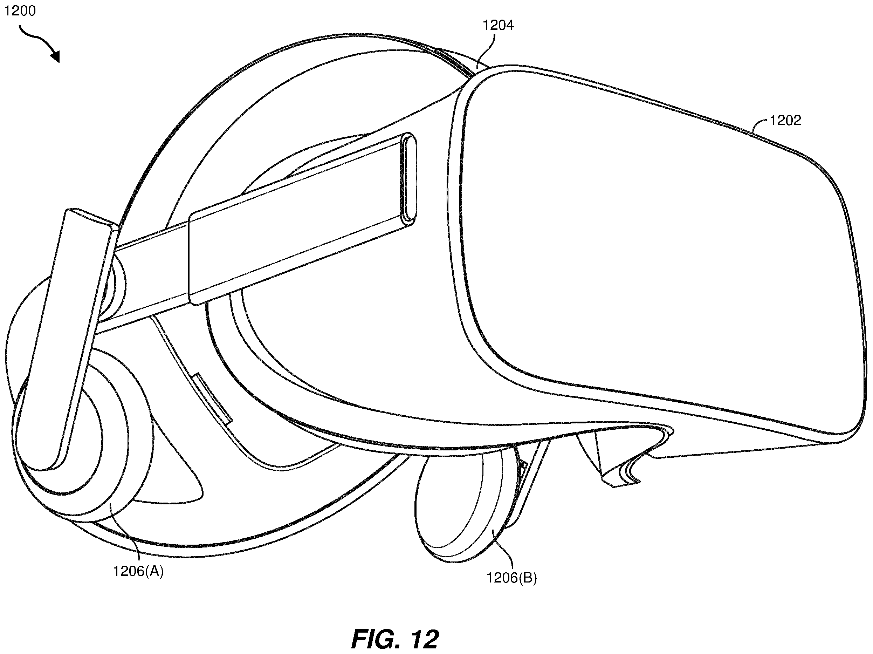

FIG. 3 illustrates an embodiment of a system 300 that may include multiple different antennas. The system 300 may be a mobile electronic device or may be a portion of an electronic device. In some examples, the system 300 may be a bezel or capsule portion of a smartwatch. As noted above, this capsule may be detachable from a wristband base that is designed to receive and hold the capsule. In other cases, it should be noted, the antenna architectures and embodiments described herein may be applied to other mobile devices including augmented reality devices (e.g., as shown in FIG. 11), virtual reality devices (e.g., as shown in FIG. 12), smartphones, tablets, internet of things devices, wearable electronic devices, gaming devices, or other electronic devices.

The system 300 may include an enclosure 301. The enclosure may be metallic, or may be made of another type of conductive material. The enclosure may be conductive over its entirety, or may be conductive only in certain portions. In some cases, the system 300 may include a bottom cover portion 308 that is made of plastic or other nonconductive material. The system 300 may include a display 303 such as a touchscreen organic light emitting diode (OLED) display. A copper foil or other electromagnetic shielding layer may be positioned beneath the display 303. This may shield other internal electronic components from the display (e.g., specifically from an absorbent indium tin oxide (ITO) layer) and may preserve antenna efficiency for the antennas below the display 303.

In some embodiments, this shielding layer may be driven as an antenna and may be referred to herein as a "top antenna" or "top layer antenna 302." The top layer antenna 302 may be configured to operate at specific frequencies. Indeed, in at least some of the embodiments herein, the top layer antenna 302 may be configured to operate at frequencies above approximately 1GHz (e.g., plus or minus 100MHz). Such frequencies are often absorbed by the user's body and, by being placed near the top of the device (e.g., when worn on a user's wrist), the top layer antenna 302 may experience less absorption and greater operating efficiency.

The top layer antenna 302 may be positioned above the battery 304, which itself is positioned above the main printed circuit board (PCB) 305. The main PCB 305 may be positioned substantially in the center of the system 300, and may have multiple electronic components embedded thereon. Such components may include antennas, antenna feeds (e.g., amplifiers, impedance matching circuits, tuners, signal processors, etc.), processors, volatile and/or nonvolatile memory, or other electronic components. In some cases, the main PCB 305 may be linked to multiple antennas, including the top layer antenna 302 and two or more different bottom layer antennas (e.g., 306). The bottom layer antennas may be positioned below a secondary PCB (e.g., a sensor PCB 307) that may include various sensors including heart rate sensors, cameras, or other sensors. The bottom layer antenna 306 may be configured to operate at frequencies below approximately 1GHz (e.g., plus or minus 100MHz). Because such frequencies are not as readily absorbed by the user's body, the bottom layer antenna 306 may be positioned at or near the bottom of the capsule and may be placed near the user's body.

FIG. 4 illustrates a top view of a system 400 that may be the same as or different than system 300 of FIG. 3. The system 400 of FIG. 4 may include an enclosure 401 that surrounds at least the side portions of the inner components. In this top view embodiment, the display and the electromagnetic shielding layer have been removed. As such, the main PCB 402 is visible below the battery 403. Additional electronic components including speakers 405 and a camera 404 are also visible. This top view indicates that, at least in some embodiments, the main PCB (and/or the electromagnetic shielding layer) may extend to the inner surface of the metal enclosure. In some cases, there may be little to no keepout space between the PCB or shield and the inner surface of the enclosure. This may help isolate the bottom antenna(s) from the lossy display on the top layer. This additional isolation may improve the operational efficiency of the lower layer antennas, and may specifically improve low-band cellular performance.

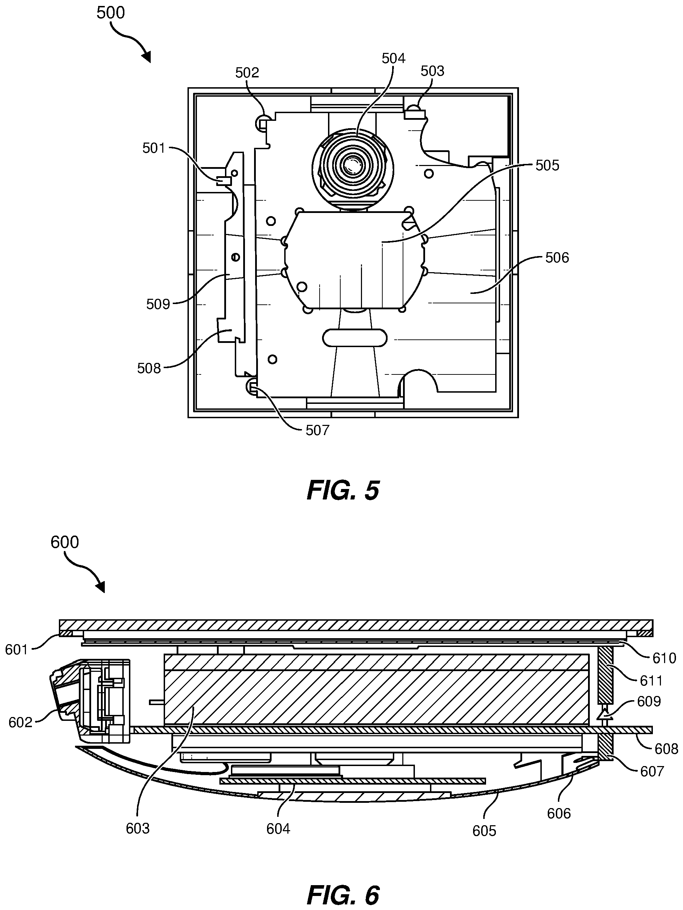

FIG. 5 illustrates an embodiment of a system 500 that may be similar to or the same as systems 300 and 400 of FIGS. 3 and 4, respectively. FIG. 5 is a bottom view of the system 500 and illustrates electronic components that are on the bottom of the device. The system 500 may include, for example, two different antennas, 506 and 508. Each antenna may be connected to different antenna feeds. For instance, the larger antenna 506 may be electrically connected to antenna feed 502, while the smaller antenna 508 is electrically connected to antenna feed 501. Because these antennas are connected to different antenna feeds, each may be driven at different frequencies and at different amplitudes. These antennas are illustrated as being patch antennas, although it will be understood that any of the antennas in the embodiments described herein may be substantially any type of antenna including monopole, dipole, loop, slot, inverted-F antenna (IFA) or planar inverted-F antenna (PIFA), bowtie, or other type of antenna.

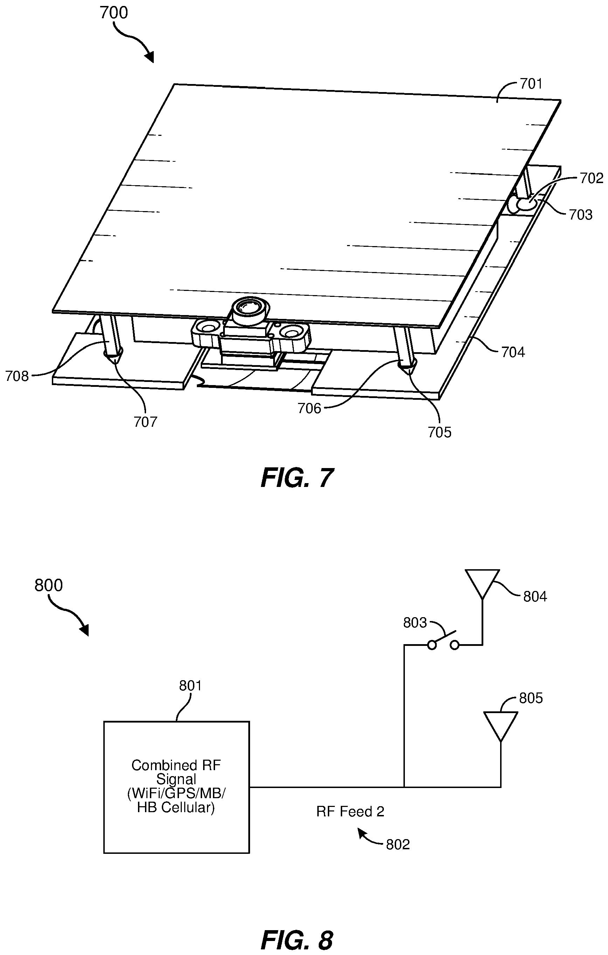

In some cases, the larger antenna 506 may be implemented for lower frequency transmission and reception, including operating in various cellular bands. In some embodiments, the larger antenna 506 may be electrically connected to one or more tuners 503 and/or 507. These tuners may be impedance tuners, aperture tuners, or other types of tuners. The tuners 503/507 may tune the larger antenna 506 to different cellular frequency bands, or to other frequencies as desired. In some cases, the larger antenna 506 may include a cutout 505 or aperture for sensors (e.g., heart rate sensors) or other electronic components including camera 504. The larger and smaller antennas 506/508 may be electrically connected to the main PCB 509 including through the antenna feeds 501 and 502. In some cases, the smaller antenna 508 may be configured to operate in conjunction with the top layer antenna 302 of FIG. 3. Indeed, as will be shown with regard to FIGS. 7 and 8, the top layer antenna 302 and the smaller, bottom antenna 508 may be electrically linked via a decoupling switch.

A decoupling switch is illustrated in system 600 of FIG. 6. The decoupling switch 609 may selectively link a top layer antenna 610 that is below a display 601 to the smaller lower layer antenna 606. The decoupling switch 609 may couple the top layer antenna 610 to the smaller lower layer antenna 606 when closed, and may decouple the top layer antenna 610 from the smaller lower layer antenna 606 when open. This may allow the two antennas to operate together in some circumstances and to work separately in others. A controller or processor on the main PCB 608 may determine when and which control signals are sent to the switch to open or close the decoupling switch 609.

In addition to the decoupling switch 609, the system 600 may also include a speaker module 602, a battery 603, a sensor PCB 604 having one or more sensors, and a larger bottom layer antenna 605. Although not shown in FIG. 6, the system 600 may include an enclosure that houses the various components, including the main PCB 608, the antenna 610 affixed to an upper layer of the enclosure above the PCB, the antenna 606 affixed to a lower layer of the enclosure below the PCB. In some cases, the decoupling switch 609 of the system 600 may be configured to selectively couple the top and bottom layer antennas 610 and 606, respectively, when transmitting or receiving signals above a specified minimum frequency (e.g., approximately 1GHz) and may be configured to decouple the top and bottom layer antennas when transmitting or receiving signals below a specified maximum frequency (e.g., approximately 1GHz). In some cases, the top layer antenna 610 may be electrically linked to the decoupling switch 609 via a spring clip 611 or other conductive fastening mechanism. Similarly, the smaller bottom layer antenna 606 may be electrically linked to the decoupling switch 609 via a spring clip 607 or other conductive fastening mechanism. The larger bottom layer antenna 605 may be directly linked to the main PCB 608 via a trace or other electrical connection.

FIG. 7 illustrates an embodiment of a system 700 that includes a top layer antenna 701 that is connected to a main PCB 704 via a decoupling switch 702. The top layer antenna 701 may be an electromagnetic shield that is positioned below a touchscreen display (not shown in FIG. 7). In some cases, the main PCB 704 may have a keepout area 703 around the decoupling switch 702. The system 700 may also include antenna tuners 705 and/or 707. These tuners may be configured to tune the upper layer antenna 701. The tuners 705/707 may be connected to the top layer antenna 701 via spring clips (e.g., 706 or 708) or via other electrical connecting mechanisms. These tuners may allow for dynamic tuning between different frequency bands, including cellular bands.

In this embodiment, the conductive shield placed beneath the touchscreen display may be driven at an antenna feed point. In this manner, the conductive shield may itself be or may function as the top layer antenna 701. The tuners on the conductive shield (e.g., tuners 705 and 707) may include aperture tuners or impedance tuners. In some cases, as noted above, the main PCB 704 may extend to the inner surface of a conductive enclosure that surrounds the internal components. In such cases, the PCB 70 may be electrically grounded to the enclosure and may shield the lower layer antenna from the touchscreen display.

FIG. 8 illustrates an embodiment of a diagram 800 illustrating how the decoupling switch described herein may operate. This diagram 800 may operate with any of the embodiments described above, and may specifically operate within a mobile electronic device that has a PCB within an enclosure, an upper layer antenna 804 affixed to an upper layer of the enclosure above the PCB, a smaller lower layer antenna 805 affixed to a lower layer of the enclosure below the PCB, as well as a larger lower layer antenna that is also affixed to the lower layer of the enclosure below the PCB. Each of these antennas may be patch antennas, monopole antennas, dipole antennas, slot antennas, or other types of antennas, as noted above. The mobile device may include a decoupling switch 803 that links the upper layer antenna to the smaller lower layer antenna through the PCB. The decoupling switch may be configured to selectively couple the upper layer antenna 804 and the smaller lower layer antenna 805 when transmitting or receiving specific signals or specific frequencies of signals.

In some embodiments, when the combined RF input signal 801 (which may include WiFi, GPS, mid band and high band cellular signals) includes signals below 1GHz, the decoupling switch 803 may remain in or may be controlled to enter into an open state that decouples the upper layer antenna 804 and the smaller lower layer antenna 805, thereby sending lower frequency signals 802 to the smaller lower layer antenna 805. Conversely, when the combined RF input signal 801 includes signals above 1GHz, the decoupling switch 803 may remain in or may be controlled to enter into a closed state that couples the upper layer antenna 804 and the smaller lower layer antenna 805, thereby sending higher frequency signals to both the upper layer antenna 804 and the smaller lower layer antenna 805. The combined RF signal 801 may thus be electrically linked to a single antenna feed or to multiple antenna feeds that drive the upper layer antenna 804 and the smaller lower layer antenna 805. A separate antenna feed may be implemented to drive the larger lower layer antenna (e.g., 605 of FIG. 6). By separating or combining different feeds of different frequencies, the embodiments herein may increase antenna efficiencies and may thereby reduce antenna power usage and improve battery life in the associated mobile devices.

FIG. 9 illustrates an embodiment of a system 900. The system may be a capsule for a smartwatch. The system 900 may include an upper layer antenna 901 that is positioned below a display (not shown). In this embodiment, the system 900 may include a main PCB 902 directly below the upper layer antenna 901. Furthermore, in this embodiment, the battery 903 may be positioned between the main PCB 902 and the sensor PCB 908. The sensor PCB may include one or more sensors including a camera 909. Still further, the system 900 may include a larger bottom antenna 904 with an aperture 910 for the camera 909 or other sensors, as well as a smaller bottom antenna 906. The smaller bottom antenna 906 may be electrically linked to the upper layer antenna 901 via a decoupling switch 907.

The system 900 may also include a bottom conductive shielding 905 positioned between the sensor PCB 908 and the bottom layer antennas 904 and 906. In some cases, this bottom conductive shielding 905 may be a copper foil layer or other conductive material layer. Alternatively, the sensor PCB 908 may itself function as a conductive shielding layer. This conductive shielding layer 905 may shield the upper layer components (including antenna 901) from electromagnetic radiation put off from the bottom layer antennas, as well as from potential absorption from (or potential detuning by) the user's body. This embodiment may allow for different components to be used, or may allow for existing components to be moved into different positions where they may operate in a more efficient manner.

FIG. 10 is a flow diagram of a method of manufacturing for providing, forming, creating, or otherwise generating a mobile device that includes one or more of the antenna architectures described herein. The steps shown in FIG. 10 may be performed by any suitable manufacturing equipment, including 3D printers, and may be controlled via computer-executable code and/or networked computing systems. In one example, each of the steps shown in FIG. 10 may represent an algorithm whose structure includes and/or is represented by multiple substeps, examples of which will be provided in greater detail below.

The method of manufacturing of FIG. 10 may include, at step 1010, providing a printed circuit board (PCB) (e.g., 902 of FIG. 9) within an enclosure (e.g., a conductive, potentially metallic enclosure). At step 1020, the method may include affixing an upper layer antenna 901 to an upper layer of the enclosure above the PCB 902 and, at step 1020, affixing a lower layer antenna 906 to a smaller lower layer of the enclosure below the PCB. At step 1030, the method may include providing a decoupling switch 907 that links the upper layer antenna 901 to the smaller lower layer antenna 906 through the PCB. The decoupling switch 907 may selectively couple the upper and smaller lower layer antennas 901/906 when transmitting or receiving signals above a specified minimum frequency and may decouple the upper and smaller lower layer antennas 901/906 when transmitting or receiving signals below a specified maximum frequency. These minimum and maximum frequencies may be different for different mobile devices.

Moreover, the method of manufacturing may include creating or applying tuners to a larger lower layer antenna. This may allow the larger lower layer antenna to switch between different frequencies (e.g., tuning between different cellular frequency bands). Accordingly, in this manner, the systems described herein may be provided with antenna architectures that selectively couple or decouple antennas at different locations in a device and thereby allow the device to optimally transmit and receive signals, regardless of which frequency bands are being used.

### Example Embodiments

Example 1: A system may include a printed circuit board (PCB) within an enclosure, a first antenna affixed to an upper layer of the enclosure above the PCB, a second antenna affixed to a lower layer of the enclosure below the PCB, and a decoupling switch that links the first antenna to the second antenna through the PCB, wherein the decoupling switch selectively couples the first and second antennas when transmitting or receiving signals above a specified minimum frequency and decouples the first and second antennas when transmitting or receiving signals below a specified maximum frequency.

Example 2: The system of Example 1, further comprising a third antenna affixed to the lower layer.

Example 3: The system of Example 1 or Example 2, wherein the third antenna includes one or more antenna tuners.

Example 4: The system of any of Examples 1-3, wherein the one or more antenna tuners on the third antenna allow for dynamic tuning between different frequency bands.

Example 5: The system of any of Examples 1-4, further comprising a first spring clip that electrically links the first antenna to the decoupling switch.

Example 6: The system of any of Examples 1-5, further comprising a second spring clip that electrically links the second antenna to the decoupling switch.

Example 7: The system of any of Examples 1-6, further comprising a touchscreen display and a conductive shield positioned beneath the touchscreen display.

Example 8: The system of any of Examples 1-7, wherein the conductive shield is driven, thereby functioning as the first antenna.

Example 9: The system of any of Examples 1-8, wherein the conductive shield below the touchscreen display includes one or more tuners.

Example 10: The system of any of Examples 1-9, wherein the one or more tuners on the conductive shield comprise aperture tuners.

Example 11: The system of any of Examples 1-10, wherein enclosure is made of a conductive material, and wherein the PCB extends to an inner surface of the enclosure and is electrically grounded to the enclosure.

Example 12: The system of any of Examples 1-11, wherein the PCB shields the second antenna from the touchscreen display.

Example 13: A mobile electronic device may include a printed circuit board (PCB) within an enclosure, a first antenna affixed to an upper layer of the enclosure above the PCB, a second antenna affixed to a lower layer of the enclosure below the PCB, and a decoupling switch that links the first antenna to the second antenna through the PCB, wherein the decoupling switch selectively couples the first and second antennas when transmitting or receiving signals above a specified minimum frequency and decouples the first and second antennas when transmitting or receiving signals below a specified maximum frequency.

Example 14: The mobile electronic device of Example 13, further comprising a first antenna feed integrated into the PCB, wherein the first antenna feed is electrically connected to the decoupling switch.

Example 15: The mobile electronic device of Example 13 or Example 14, further comprising a second antenna feed integrated into the PCB, wherein the second antenna feed is electrically connected to the second antenna.

Example 16: The mobile electronic device of any of Examples 13-15, further comprising a third antenna feed integrated into the PCB, wherein the third antenna feed is electrically connected to a third antenna.

Example 17: The mobile electronic device of any of Examples 13-16, wherein the third antenna comprises a patch antenna having at least one aperture for at least one sensor.

Example 18: The mobile electronic device of any of Examples 13-17, further comprising a bottom conductive shielding positioned between the PCB and the second antenna.

Example 19: The mobile electronic device of any of Examples 13-18, wherein the bottom conductive shielding comprises a second PCB.

Example 20: A method of manufacturing is provided that may include providing a printed circuit board (PCB) within an enclosure, affixing a first antenna to an upper layer of the enclosure above the PCB, affixing a second antenna to a lower layer of the enclosure below the PCB, and providing a decoupling switch that links the first antenna to the second antenna through the PCB, wherein the decoupling switch selectively couples the first and second antennas when transmitting or receiving signals above a specified minimum frequency and decouples the first and second antennas when transmitting or receiving signals below a specified maximum frequency.

Embodiments of the present disclosure may include or be implemented in conjunction with various types of artificial-reality systems. Artificial reality is a form of reality that has been adjusted in some manner before presentation to a user, which may include, for example, a virtual reality, an augmented reality, a mixed reality, a hybrid reality, or some combination and/or derivative thereof. Artificial-reality content may include completely computer-generated content or computer-generated content combined with captured (e.g., real-world) content. The artificial-reality content may include video, audio, haptic feedback, or some combination thereof, any of which may be presented in a single channel or in multiple channels (such as stereo video that produces a three-dimensional (3D) effect to the viewer). Additionally, in some embodiments, artificial reality may also be associated with applications, products, accessories, services, or some combination thereof, that are used to, for example, create content in an artificial reality and/or are otherwise used in (e.g., to perform activities in) an artificial reality.

Artificial-reality systems may be implemented in a variety of different form factors and configurations. Some artificial-reality systems may be designed to work without near-eye displays (NEDs). Other artificial-reality systems may include an NED that also provides visibility into the real world (such as, e.g., augmented-reality system 1100 in FIG. 11) or that visually immerses a user in an artificial reality (such as, e.g., virtual-reality system 1200 in FIG. 12). While some artificial-reality devices may be self-contained systems, other artificial-reality devices may communicate and/or coordinate with external devices to provide an artificial-reality experience to a user. Examples of such external devices include handheld controllers, mobile devices, desktop computers, devices worn by a user, devices worn by one or more other users, and/or any other suitable external system.

Turning to FIG. 11, augmented-reality system 1100 may include an eyewear device 1102 with a frame 1110 configured to hold a left display device 1115(A) and a right display device 1115(B) in front of a user's eyes. Display devices 1115(A) and 1115(B) may act together or independently to present an image or series of images to a user. While augmented-reality system 1100 includes two displays, embodiments of this disclosure may be implemented in augmented-reality systems with a single NED or more than two NEDs.

In some embodiments, augmented-reality system 1100 may include one or more sensors, such as sensor 1140. Sensor 1140 may generate measurement signals in response to motion of augmented-reality system 1100 and may be located on substantially any portion of frame 1110. Sensor 1140 may represent one or more of a variety of different sensing mechanisms, such as a position sensor, an inertial measurement unit (IMU), a depth camera assembly, a structured light emitter and/or detector, or any combination thereof. In some embodiments, augmented-reality system 1100 may or may not include sensor 1140 or may include more than one sensor. In embodiments in which sensor 1140 includes an IMU, the IMU may generate calibration data based on measurement signals from sensor 1140. Examples of sensor 1140 may include, without limitation, accelerometers, gyroscopes, magnetometers, other suitable types of sensors that detect motion, sensors used for error correction of the IMU, or some combination thereof.

In some examples, augmented-reality system 1100 may also include a microphone array with a plurality of acoustic transducers 1120(A)-1120(J), referred to collectively as acoustic transducers 1120. Acoustic transducers 1120 may represent transducers that detect air pressure variations induced by sound waves. Each acoustic transducer 1120 may be configured to detect sound and convert the detected sound into an electronic format (e.g., an analog or digital format). The microphone array in FIG. 11 may include, for example, ten acoustic transducers: 1120(A) and 1120(B), which may be designed to be placed inside a corresponding ear of the user, acoustic transducers 1120(C), 1120(D), 1120(E), 1120(F), 1120(G), and 1120(H), which may be positioned at various locations on frame 1110, and/or acoustic transducers 1120(I) and 1120(J), which may be positioned on a corresponding neckband 1105.

In some embodiments, one or more of acoustic transducers 1120(A)-(J) may be used as output transducers (e.g., speakers). For example, acoustic transducers 1120(A) and/or 1120(B) may be earbuds or any other suitable type of headphone or speaker.

The configuration of acoustic transducers 1120 of the microphone array may vary. While augmented-reality system 1100 is shown in FIG. 11 as having ten acoustic transducers 1120, the number of acoustic transducers 1120 may be greater or less than ten. In some embodiments, using higher numbers of acoustic transducers 1120 may increase the amount of audio information collected and/or the sensitivity and accuracy of the audio information. In contrast, using a lower number of acoustic transducers 1120 may decrease the computing power required by an associated controller 1150 to process the collected audio information. In addition, the position of each acoustic transducer 1120 of the microphone array may vary. For example, the position of an acoustic transducer 1120 may include a defined position on the user, a defined coordinate on frame 1110, an orientation associated with each acoustic transducer 1120, or some combination thereof.

Acoustic transducers 1120(A) and 1120(B) may be positioned on different parts of the user's ear, such as behind the pinna, behind the tragus, and/or within the auricle or fossa. Or, there may be additional acoustic transducers 1120 on or surrounding the ear in addition to acoustic transducers 1120 inside the ear canal. Having an acoustic transducer 1120 positioned next to an ear canal of a user may enable the microphone array to collect information on how sounds arrive at the ear canal. By positioning at least two of acoustic transducers 1120 on either side of a user's head (e.g., as binaural microphones), augmented-reality system 1100 may simulate binaural hearing and capture a 3D stereo sound field around about a user's head. In some embodiments, acoustic transducers 1120(A) and 1120(B) may be connected to augmented-reality system 1100 via a wired connection 1130, and in other embodiments acoustic transducers 1120(A) and 1120(B) may be connected to augmented-reality system 1100 via a wireless connection (e.g., a BLUETOOTH connection). In still other embodiments, acoustic transducers 1120(A) and 1120(B) may not be used at all in conjunction with augmented-reality system 1100.

Acoustic transducers 1120 on frame 1110 may be positioned in a variety of different ways, including along the length of the temples, across the bridge, above or below display devices 1115(A) and 1115(B), or some combination thereof. Acoustic transducers 1120 may also be oriented such that the microphone array is able to detect sounds in a wide range of directions surrounding the user wearing the augmented-reality system 1100. In some embodiments, an optimization process may be performed during manufacturing of augmented-reality system 1100 to determine relative positioning of each acoustic transducer 1120 in the microphone array.

In some examples, augmented-reality system 1100 may include or be connected to an external device (e.g., a paired device), such as neckband 1105. Neckband 1105 generally represents any type or form of paired device. Thus, the following discussion of neckband 1105 may also apply to various other paired devices, such as charging cases, smart watches, smart phones, wrist bands, other wearable devices, hand-held controllers, tablet computers, laptop computers, other external compute devices, etc.

As shown, neckband 1105 may be coupled to eyewear device 1102 via one or more connectors. The connectors may be wired or wireless and may include electrical and/or non-electrical (e.g., structural) components. In some cases, eyewear device 1102 and neckband 1105 may operate independently without any wired or wireless connection between them. While FIG. 11 illustrates the components of eyewear device 1102 and neckband 1105 in example locations on eyewear device 1102 and neckband 1105, the components may be located elsewhere and/or distributed differently on eyewear device 1102 and/or neckband 1105. In some embodiments, the components of eyewear device 1102 and neckband 1105 may be located on one or more additional peripheral devices paired with eyewear device 1102, neckband 1105, or some combination thereof.

Pairing external devices, such as neckband 1105, with augmented-reality eyewear devices may enable the eyewear devices to achieve the form factor of a pair of glasses while still providing sufficient battery and computation power for expanded capabilities. Some or all of the battery power, computational resources, and/or additional features of augmented-reality system 1100 may be provided by a paired device or shared between a paired device and an eyewear device, thus reducing the weight, heat profile, and form factor of the eyewear device overall while still retaining desired functionality. For example, neckband 1105 may allow components that would otherwise be included on an eyewear device to be included in neckband 1105 since users may tolerate a heavier weight load on their shoulders than they would tolerate on their heads. Neckband 1105 may also have a larger surface area over which to diffuse and disperse heat to the ambient environment. Thus, neckband 1105 may allow for greater battery and computation capacity than might otherwise have been possible on a stand-alone eyewear device. Since weight carried in neckband 1105 may be less invasive to a user than weight carried in eyewear device 1102, a user may tolerate wearing a lighter eyewear device and carrying or wearing the paired device for greater lengths of time than a user would tolerate wearing a heavy standalone eyewear device, thereby enabling users to more fully incorporate artificial-reality environments into their day-to-day activities.

Neckband 1105 may be communicatively coupled with eyewear device 1102 and/or to other devices. These other devices may provide certain functions (e.g., tracking, localizing, depth mapping, processing, storage, etc.) to augmented-reality system 1100. In the embodiment of FIG. 11, neckband 1105 may include two acoustic transducers (e.g., 1120(I) and 1120(J)) that are part of the microphone array (or potentially form their own microphone subarray). Neckband 1105 may also include a controller 1125 and a power source 1135.

Acoustic transducers 1120(I) and 1120(J) of neckband 1105 may be configured to detect sound and convert the detected sound into an electronic format (analog or digital). In the embodiment of FIG. 11, acoustic transducers 1120(I) and 1120(J) may be positioned on neckband 1105, thereby increasing the distance between the neckband acoustic transducers 1120(I) and 1120(J) and other acoustic transducers 1120 positioned on eyewear device 1102. In some cases, increasing the distance between acoustic transducers 1120 of the microphone array may improve the accuracy of beamforming performed via the microphone array. For example, if a sound is detected by acoustic transducers 1120(C) and 1120(D) and the distance between acoustic transducers 1120(C) and 1120(D) is greater than, e.g., the distance between acoustic transducers 1120(D) and 1120(E), the determined source location of the detected sound may be more accurate than if the sound had been detected by acoustic transducers 1120(D) and 1120(E).

Controller 1125 of neckband 1105 may process information generated by the sensors on neckband 1105 and/or augmented-reality system 1100. For example, controller 1125 may process information from the microphone array that describes sounds detected by the microphone array. For each detected sound, controller 1125 may perform a direction-of-arrival (DOA) estimation to estimate a direction from which the detected sound arrived at the microphone array. As the microphone array detects sounds, controller 1125 may populate an audio data set with the information. In embodiments in which augmented-reality system 1100 includes an inertial measurement unit, controller 1125 may compute all inertial and spatial calculations from the IMU located on eyewear device 1102. A connector may convey information between augmented-reality system 1100 and neckband 1105 and between augmented-reality system 1100 and controller 1125. The information may be in the form of optical data, electrical data, wireless data, or any other transmittable data form. Moving the processing of information generated by augmented-reality system 1100 to neckband 1105 may reduce weight and heat in eyewear device 1102, making it more comfortable to the user.

Power source 1135 in neckband 1105 may provide power to eyewear device 1102 and/or to neckband 1105. Power source 1135 may include, without limitation, lithium-ion batteries, lithium-polymer batteries, primary lithium batteries, alkaline batteries, or any other form of power storage. In some cases, power source 1135 may be a wired power source. Including power source 1135 on neckband 1105 instead of on eyewear device 1102 may help better distribute the weight and heat generated by power source 1135.

As noted, some artificial-reality systems may, instead of blending an artificial reality with actual reality, substantially replace one or more of a user's sensory perceptions of the real world with a virtual experience. One example of this type of system is a head-worn display system, such as virtual-reality system 1200 in FIG. 12, that mostly or completely covers a user's field of view. Virtual-reality system 1200 may include a front rigid body 1202 and a band 1204 shaped to fit around a user's head. Virtual-reality system 1200 may also include output audio transducers 1206(A) and 1206(B). Furthermore, while not shown in FIG. 12, front rigid body 1202 may include one or more electronic elements, including one or more electronic displays, one or more inertial measurement units (IMUs), one or more tracking emitters or detectors, and/or any other suitable device or system for creating an artificial-reality experience.

Artificial-reality systems may include a variety of types of visual feedback mechanisms. For example, display devices in augmented-reality system 1100 and/or virtual-reality system 1200 may include one or more liquid crystal displays (LCDs), light emitting diode (LED) displays, microLED displays, organic LED (OLED) displays, digital light project (DLP) micro-displays, liquid crystal on silicon (LCoS) micro-displays, and/or any other suitable type of display screen. These artificial-reality systems may include a single display screen for both eyes or may provide a display screen for each eye, which may allow for additional flexibility for varifocal adjustments or for correcting a user's refractive error. Some of these artificial-reality systems may also include optical subsystems having one or more lenses (e.g., concave or convex lenses, Fresnel lenses, adjustable liquid lenses, etc.) through which a user may view a display screen. These optical subsystems may serve a variety of purposes, including to collimate (e.g., make an object appear at a greater distance than its physical distance), to magnify (e.g., make an object appear larger than its actual size), and/or to relay (to, e.g., the viewer's eyes) light. These optical subsystems may be used in a non-pupil-forming architecture (such as a single lens configuration that directly collimates light but results in so-called pincushion distortion) and/or a pupil-forming architecture (such as a multi-lens configuration that produces so-called barrel distortion to nullify pincushion distortion).

In addition to or instead of using display screens, some of the artificial-reality systems described herein may include one or more projection systems. For example, display devices in augmented-reality system 1100 and/or virtual-reality system 1200 may include microLED projectors that project light (using, e.g., a waveguide) into display devices, such as clear combiner lenses that allow ambient light to pass through. The display devices may refract the projected light toward a user's pupil and may enable a user to simultaneously view both artificial-reality content and the real world. The display devices may accomplish this using any of a variety of different optical components, including waveguide components (e.g., holographic, planar, diffractive, polarized, and/or reflective waveguide elements), light-manipulation surfaces and elements (such as diffractive, reflective, and refractive elements and gratings), coupling elements, etc. Artificial-reality systems may also be configured with any other suitable type or form of image projection system, such as retinal projectors used in virtual retina displays.

The artificial-reality systems described herein may also include various types of computer vision components and subsystems. For example, augmented-reality system 1100 and/or virtual-reality system 1200 may include one or more optical sensors, such as two-dimensional (2D) or 3D cameras, structured light transmitters and detectors, time-of-flight depth sensors, single-beam or sweeping laser rangefinders, 3D LiDAR sensors, and/or any other suitable type or form of optical sensor. An artificial-reality system may process data from one or more of these sensors to identify a location of a user, to map the real world, to provide a user with context about real-world surroundings, and/or to perform a variety of other functions.

The artificial-reality systems described herein may also include one or more input and/or output audio transducers. Output audio transducers may include voice coil speakers, ribbon speakers, electrostatic speakers, piezoelectric speakers, bone conduction transducers, cartilage conduction transducers, tragus-vibration transducers, and/or any other suitable type or form of audio transducer. Similarly, input audio transducers may include condenser microphones, dynamic microphones, ribbon microphones, and/or any other type or form of input transducer. In some embodiments, a single transducer may be used for both audio input and audio output.

In some embodiments, the artificial-reality systems described herein may also include tactile (i.e., haptic) feedback systems, which may be incorporated into headwear, gloves, body suits, handheld controllers, environmental devices (e.g., chairs, floormats, etc.), and/or any other type of device or system. Haptic feedback systems may provide various types of cutaneous feedback, including vibration, force, traction, texture, and/or temperature. Haptic feedback systems may also provide various types of kinesthetic feedback, such as motion and compliance. Haptic feedback may be implemented using motors, piezoelectric actuators, fluidic systems, and/or a variety of other types of feedback mechanisms. Haptic feedback systems may be implemented independent of other artificial-reality devices, within other artificial-reality devices, and/or in conjunction with other artificial-reality devices.

By providing haptic sensations, audible content, and/or visual content, artificial-reality systems may create an entire virtual experience or enhance a user's real-world experience in a variety of contexts and environments. For instance, artificial-reality systems may assist or extend a user's perception, memory, or cognition within a particular environment. Some systems may enhance a user's interactions with other people in the real world or may enable more immersive interactions with other people in a virtual world. Artificial-reality systems may also be used for educational purposes (e.g., for teaching or training in schools, hospitals, government organizations, military organizations, business enterprises, etc.), entertainment purposes (e.g., for playing video games, listening to music, watching video content, etc.), and/or for accessibility purposes (e.g., as hearing aids, visual aids, etc.). The embodiments disclosed herein may enable or enhance a user's artificial-reality experience in one or more of these contexts and environments and/or in other contexts and environments.

As detailed above, the computing devices and systems described and/or illustrated herein broadly represent any type or form of computing device or system capable of executing computer-readable instructions, such as those contained within the modules described herein. In their most basic configuration, these computing device(s) may each include at least one memory device and at least one physical processor.

In some examples, the term "memory device" generally refers to any type or form of volatile or non-volatile storage device or medium capable of storing data and/or computer-readable instructions. In one example, a memory device may store, load, and/or maintain one or more of the modules described herein. Examples of memory devices include, without limitation, Random Access Memory (RAM), Read Only Memory (ROM), flash memory, Hard Disk Drives (HDDs), Solid-State Drives (SSDs), optical disk drives, caches, variations or combinations of one or more of the same, or any other suitable storage memory.

In some examples, the term "physical processor" generally refers to any type or form of hardware-implemented processing unit capable of interpreting and/or executing computer-readable instructions. In one example, a physical processor may access and/or modify one or more modules stored in the above-described memory device. Examples of physical processors include, without limitation, microprocessors, microcontrollers, Central Processing Units (CPUs), Field-Programmable Gate Arrays (FPGAs) that implement softcore processors, Application-Specific Integrated Circuits (ASICs), portions of one or more of the same, variations or combinations of one or more of the same, or any other suitable physical processor.

Although illustrated as separate elements, the modules described and/or illustrated herein may represent portions of a single module or application. In addition, in certain embodiments one or more of these modules may represent one or more software applications or programs that, when executed by a computing device, may cause the computing device to perform one or more tasks. For example, one or more of the modules described and/or illustrated herein may represent modules stored and configured to run on one or more of the computing devices or systems described and/or illustrated herein. One or more of these modules may also represent all or portions of one or more special-purpose computers configured to perform one or more tasks.

In addition, one or more of the modules described herein may transform data, physical devices, and/or representations of physical devices from one form to another. Additionally or alternatively, one or more of the modules recited herein may transform a processor, volatile memory, non-volatile memory, and/or any other portion of a physical computing device from one form to another by executing on the computing device, storing data on the computing device, and/or otherwise interacting with the computing device.

In some embodiments, the term "computer-readable medium" generally refers to any form of device, carrier, or medium capable of storing or carrying computer-readable instructions. Examples of computer-readable media include, without limitation, transmission-type media, such as carrier waves, and non-transitory-type media, such as magnetic-storage media (e.g., hard disk drives, tape drives, and floppy disks), optical-storage media (e.g., Compact Disks (CDs), Digital Video Disks (DVDs), and BLU-RAY disks), electronic-storage media (e.g., solid-state drives and flash media), and other distribution systems.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various exemplary methods described and/or illustrated herein may also omit one or more of the steps described or illustrated herein or include additional steps in addition to those disclosed.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the present disclosure. The embodiments disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

## Claims

1. A system comprising:
a printed circuit board (PCB) within an enclosure;
a first antenna affixed to an upper layer of the enclosure above the PCB;
a second antenna affixed to a lower layer of the enclosure below the PCB; and
a decoupling switch that links the first antenna to the second antenna through the PCB, wherein the decoupling switch selectively couples the first and second antennas when transmitting or receiving signals above a specified minimum frequency and decouples the first and second antennas when transmitting or receiving signals below a specified maximum frequency.

2. The system of claim 1, further comprising a third antenna affixed to the lower layer.

3. The system of claim 2, wherein the third antenna includes one or more antenna tuners and optionally,
wherein the one or more antenna tuners on the third antenna allow for dynamic tuning between different frequency bands.

4. The system of any preceding claim, further comprising a first spring clip that electrically links the first antenna to the decoupling switch; and optionally
further comprising a second spring clip that electrically links the second antenna to the decoupling switch.

5. The system of any preceding claim, further comprising a touchscreen display and a conductive shield positioned beneath the touchscreen display.

6. The system of claim 5, wherein the conductive shield is driven, thereby functioning as the first antenna.

7. The system of claim 5 or 6, wherein the conductive shield below the touchscreen display includes one or more tuners, optionally comprising aperture tuners.

8. The system of one of claims 5 to 7, wherein enclosure is made of a conductive material, and wherein the PCB extends to an inner surface of the enclosure and is electrically grounded to the enclosure.

9. The system of claim 8, wherein the PCB shields the second antenna from the touchscreen display.

10. A mobile electronic device, comprising a system in accordance with any prceding claim.

11. The mobile electronic device of claim 10, further comprising a first antenna feed integrated into the PCB, wherein the first antenna feed is electrically connected to the decoupling switch.

12. The mobile electronic device of claim 11, further comprising a second antenna feed integrated into the PCB, wherein the second antenna feed is electrically connected to the second antenna.

13. The mobile electronic device of claim 12, further comprising a third antenna feed integrated into the PCB, wherein the third antenna feed is electrically connected to a third antenna; wherein the third antenna optionally comprises a patch antenna having at least one aperture for at least one sensor.

14. The mobile electronic device of one of claims 10 to 13, further comprising a bottom conductive shielding positioned between the PCB and the second antenna; wherein the bottom conductive shielding optionally comprises a second PCB.

15. A method of manufacturing, comprising:
providing a printed circuit board (PCB) within an enclosure;
affixing a first antenna to an upper layer of the enclosure above the PCB;
affixing a second antenna to a lower layer of the enclosure below the PCB; and
providing a decoupling switch that links the first antenna to the second antenna through the PCB, wherein the decoupling switch selectively couples the first and second antennas when transmitting or receiving signals above a specified minimum frequency and decouples the first and second antennas when transmitting or receiving signals below a specified maximum frequency.
